# EUROPÄISCHE PATENTSCHRIFT

(11) **EP 1 316 997 B1**
(45) Veröffentlichungstag und Bekanntmachung des Hinweises auf die Patenterteilung: **17.10.2007**
(21) Anmeldenummer: 02026281.2
(22) Anmeldetag: 27.11.2002
(51) Int. Cl.: H01L 23/48

(54) **Umrichter in Druckkontaktierung**
Press contact converter
Convertisseur à contact par pression

(30) Priorität: 01.12.2001 DE 10159119
(43) Veröffentlichungstag der Anmeldung: 04.06.2003
(73) Patentinhaber: SEMIKRON Elektronik GmbH & Co. KG, 90431 Nürnberg (DE)
(72) Erfinder: Frank, Thomas, 91207 Lauf (DE)

(56) Entgegenhaltungen:
- EP-A- 0 662 732
- DE-A1- 19 942 770
- DE-C1- 10 127 947
- US-A- 5 329 423
- US-A- 5 499 924

## Beschreibung

Die Erfindung betrifft einen Umrichter in Druckkontaktierung bestehend aus einem Grundkörper, einem Substrat mit darauf angeordneten schaltungsgerecht miteinander verbunden Halbleiterbauelementen sowie auf diesem Substrat vorgesehenen Kontaktstellen, Stromanschlusselementen für Gleich- und Wechselspannungsanschlüsse zur Kontaktierung dieser Kontaktstellen sowie zur Kontaktierung eines Gleichstromzwischenkreises und des Wechselstromanschlusses.

Derartige druckkontaktierte Schaltungsanordnungen werden beispielhaft in der DE 101 27 947 offenbart. Bei Umrichtern der Leistungsklasse besonders wichtige Aspekte sind eine niederinduktive Stromzufuhr aus dem Zwischenkreis sowie eine hohe Stromtragfähigkeit aller Komponenten der Leistungsanschlüsse, d.h. der Plus- und Minusanschlüsse des Zwischenkreises sowie der Wechselstromanschlüsse. In druckkontaktierten Umrichtern bilden den Stand der Technik verschiedene Verbindungstechniken zwischen den verschieden Kontaktstellen, z.B. auf dem Substrat oder auf der Zwischenkreisplatine und mit den Stromanschlusselementen.

Bekannt sind Warzen auf den Kontaktstellen des Zwischenkreises, die mittels eines flächig ausgebildeten Anschlusselements kontaktiert werden. Nachteilig ist hierbei, dass die Warzen zum Teil eine unterschiedliche Höhe aufweisen und daher der Kontakt nicht mit allen Warzen oder zumindest nicht vollständig hergestellt wird. Noch entscheidender ist, dass die Warzen durch ihre kugelsegmentartige Form nur eine geringe gemeinsame Kontaktfläche mit der planen Oberfläche des Anschlusselements aufweisen. Dies schränkt die Stromtragfähigkeit derartiger Verbindungen entscheidend ein, da die stromdurchflossene Fläche ein direktes Maß für die Stromtragfähigkeit darstellt.

Ebenfalls bekannt sind plane Kontaktstellen beispielhaft die Kontaktstellen des Substrats sowie Erhebungen auf den Anschlusselementen mit einer sägezahnartig ausgebildeten der Kontaktstelle zugewandten Oberfläche. Der wesentliche Nachteil dieser Ausgestaltung ist ebenfalls die geringe Kontaktfläche und damit die ungenügende Stromtragfähigkeit dieser Verbindungen.

Eine weitere nach dem Stand der Technik bekannte Verbindung ist die stoffschlüssige Verbindung, wie sie beispielhaft durch Löten erfolgen kann. Großflächige Lötverbindungen weisen allerdings in Leistungshalbleitermodulen den Nachteil der geringen Dauerhaltbarkeit auf Grund der mangelhaften Lastwechselfähigkeit auf.

Die US 5,329,423 offenbart eine Verbindungseinrichtung für geringe Leistungen, wobei die zu verbindenden Bauelemente beispielhaft integrierte Schaltkreise (IC) in Mulit-Chip-Modulen sind. Hier werden einzelne Kontakteinrichtungen beispielhaft eines Bauelementes (IC) durch Warzen ausgebildet, die mit entsprechenden Aufnahmen eines zu kontaktierenden Gegenstücks eine gemeinsame Kontaktfläche aufweisen.

Der vorliegenden Erfindung liegt die Aufgabe zugrunde einen Umrichter vorzustellen, wobei die Hauptanschlüsse in Druckkontaktierung ausgeführt sind und die Kontaktflächen möglichst groß sind um eine hohe Stromtragfähigkeit zu gewährleisten sowie eine niederinduktive Ankopplung zu erlauben.

Die Aufgabe wird gelöst durch die Maßnahmen des Anspruchs 1. Weitere vorteilhafte Ausgestaltungen sind in den Unteransprüchen genannt.

Der Grundgedanke der Erfindung liegt in der Verformung von Warzen durch die Druckkontaktierung des Leistungshalbleitermoduls. Hierzu werden auf den Kontaktstellen verformbare Warzen aufgebracht, welche durch eine Mehrzahl von Erhebungen der Anschlusselemente jeweils nur teilweise überdeckt werden. Bei der Druckkontaktierung dieser Warzen werden diese derart verformt, dass sie sich an die Kontur der Erhebungen der Anschlusselemente anpassen und damit ein möglichst große gemeinsame Oberfläche mit diesen bilden. Dies kommt unmittelbar der Stromtragfähigkeit dieser Verbindungen zugute.

Ein weiterer Vorteil der Erfindung liegt im Ausgleich geringer Höhendifferenzen einzelner Warzen und / oder einzelner Erhebungen der Anschlusselemente zueinander, da die Warzen durch die Druckkontaktierung verformt werden und somit ein sicherer und flächiger Kontakt hergestellt wird.

Nachfolgend werden die Merkmale und Ausgestaltungen der Erfindung an Hand der Fig. 1 bis 6 beispielhaft erläutert.

Fig. 1 zeigt eine Ausgestaltung von Stromanschlusselementen zur Kontaktierung innerhalb eines Umrichters nach dem Stand der Technik.

Fig. 2 zeigt eine weitere Ausgestaltung von Stromanschlusselementen zur Kontaktierung innerhalb eines Umrichters nach dem Stand der Technik.

Fig. 3 zeigt die erfinderische Ausgestaltung der Einzelteile von Stromanschlusselementen zur Kontaktierung innerhalb eines Umrichters.

Fig. 4 zeigt die Wirkungsweise der erfinderische Ausgestaltung von Stromanschlusselementen zur Kontaktierung innerhalb eines Umrichters.

Fig. 5 zeigt eine weitere Ausgestaltungen von erfinderischen Stromanschlusselementen zur Kontaktierung.

Fig. 6 zeigt verschiedene Ausgestaltungen von erfinderischen Stromanschlusselementen zur Kontaktierung in Draufsicht.

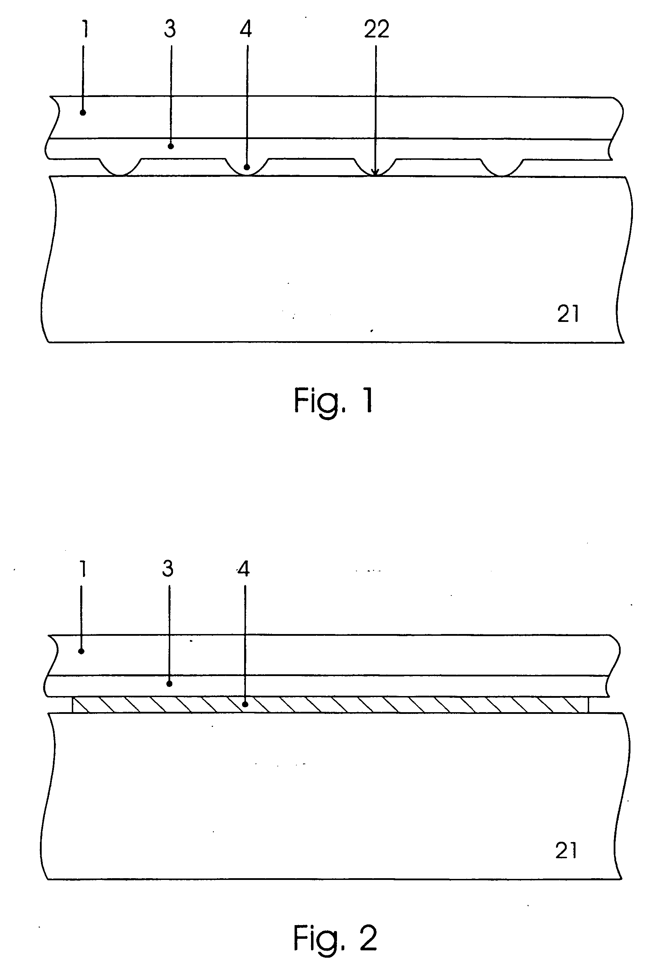

Fig. 1 zeigt eine Ausgestaltung von Stromanschlusselementen (21) zur Kontaktierung innerhalb eines Umrichters nach dem Stand der Technik. Das Gegenstück (1) der Stromanschlusselemente (21) zur Kontaktierung weist eine leitende Schicht (3) mit darauf angeordneten Warzen (4) auf, die bei Druckkontaktierung des Umrichters die elektrisch leitende Verbindung zwischen den Stromanschlusselementen (21)zur Kontaktierung und ihrem jeweiligen Gegenstück (1) herstellen. Die leitende Fläche ist hierbei auf die sehr kleine Kontaktfläche (22) beschränkt.

Fig. 2 zeigt eine weitere Ausgestaltung von Stromanschlusselementen zur Kontaktierung innerhalb eines Umrichters nach dem Stand der Technik. Hierbei wird um den Nachteil der geringen Kontaktflächen (vgl. Fig. 1) zu vermeiden das Stromanschlusselement zur Kontaktierung (21) mittels einer stoffschlüssigen Verbindung (z.B. Lot) direkt mit der leitenden Schicht (3) des entsprechenden Gegenstücks (1) verbunden.

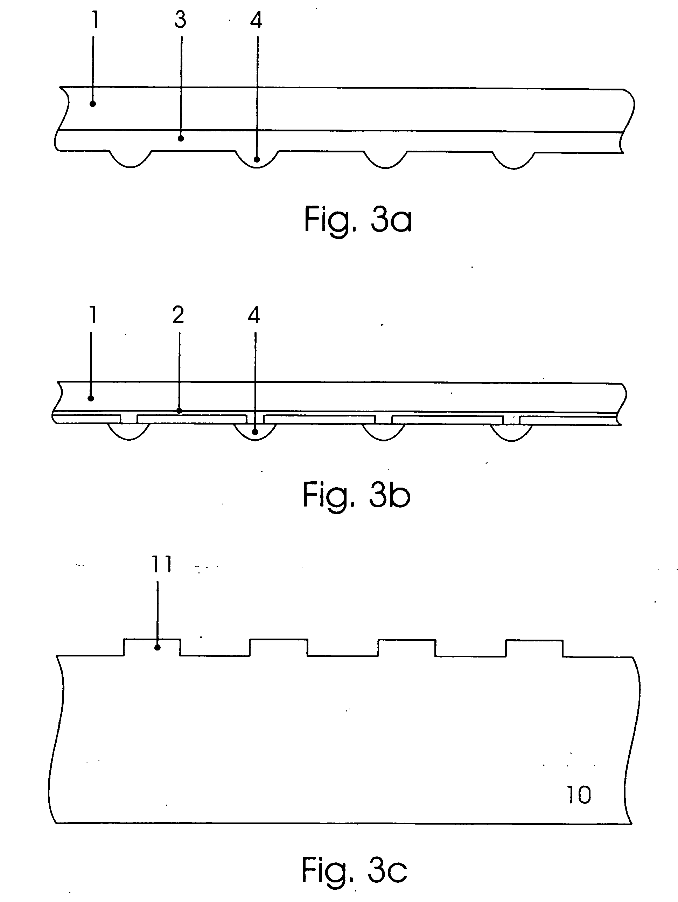

Fig. 3 zeigt die erfinderische Ausgestaltung der Einzelteile von Stromanschlussementen (10) zur Kontaktierung innerhalb eines Umrichters. Das als einstückiges Metallpressteil ausgestaltete Stromanschlusselement (10) zur Kontaktierung weist Erhebungen (11) auf (Fig. 3c). Das Gegenstück (1) weist beispielsweise eine innerhalb desselben liegende elektrisch leitende Schicht mit Verbindungen zu der den Stromanschlusselementen (10) zur Kontaktierung zugewandten Oberfläche auf. Auf diesen Verbindungen sind mit ihnen elektrisch leitend verbundene Warzen (4) aus Weichlot angeordnet (Fig. 3b). Eine weitere Ausgestaltung (Fig. 3a) des Gegenstücks (1) der Stromanschlusselementen (10) zur Kontaktierung entspricht derjenigen in Fig. 1 bereits beschriebenen mit einer elektrisch leitenden Schicht (3) auf der den Stromanschlusselementen zur Kontaktierung zugewandten Seite und darauf angeordneten Warzen (4).

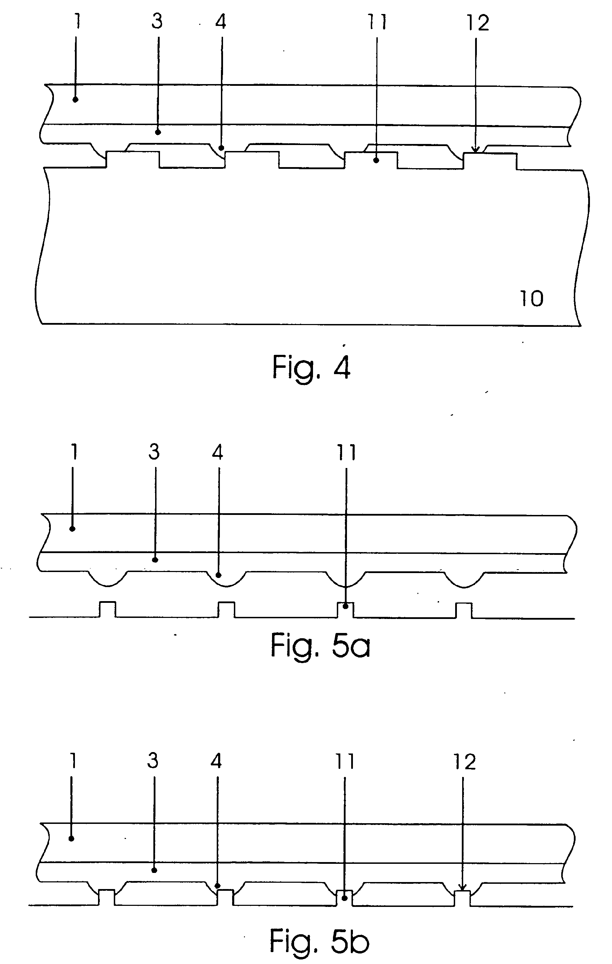

Fig. 4 zeigt die Wirkungsweise der erfinderischen Ausgestaltung von Stromanschlusselementen zur Kontaktierung innerhalb eines Umrichters. Das Stromanschlusselement zur Kontaktierung (10) ist derart zu seinem Gegenstück (1) angeordnet, dass die Erhebungen (11) des Stromanschlusselementen zur Kontaktierung (10) die Grundfläche der Warzen (4) nicht vollständig überdecken, sondern einen seitlichen Versatz aufweisen. Mittels der Druckeinleitung des druckkontaktierten Aufbaus des Umrichters werden die Warzen (4) durch die Erhebungen(11) teilweise derart verformt, dass sich eine Kontaktfläche (12) zwischen den Erhebungen (11) und den Warzen (4) ergibt, die in ihrer Gesamtheit mindestens ein Fünftel der Grundfläche der Warzen (4) aufweist.

Fig. 5 zeigt eine weitere Ausgestaltung der erfinderischen Stromanschlusselemente (10) zur Kontaktierung. Hierbei ist die Grundfläche der Erhebungen (11) kleiner als die Grundfläche der Warzen (4) (Fig. 5a). Auch damit ergibt sich nach Druckeinleitung des druckkontaktierten Aufbaus (Fig. 5b) eine Verformung der Warzen (4) derart, dass die jeweilige Kontaktfläche (12) größer ist als ein Fünftel der Warzengrundfläche.

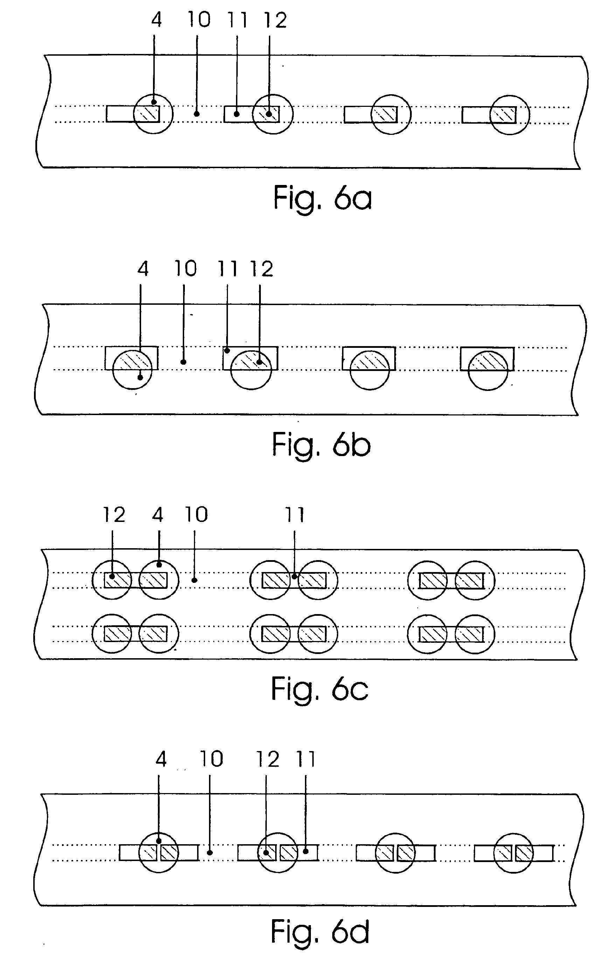

Fig. 6 zeigt verschiedene Ausgestaltungen der erfinderischen Stromanschlusselemente (10) zur Kontaktierung in Draufsicht. Fig. 6a zeigt die Draufsicht der Ausgestaltung nach Fig. 4. Hierbei ist der Anteil, parallel zur Oberfläche des Gegenstücks (1) der Stromanschlusselementen (10) zur Kontaktierung, der Kontaktfläche (12) zwischen den Erhebungen (11) und den Warzen (4) sowie deren Anordnung in Reihe deutlich zu erkennen. Fig. 6b zeigt eine Ausgestaltung mit einem Versatz der Warzen (4) zu den Stromanschlusselementen (10) zur Kontaktierung nicht in Richtung der Längsausdehnung der Stromanschlusselemente zur Kontaktierung, sondern orthogonal hierzu. Fig. 6c zeigt eine weitere erfinderische Ausgestaltung derart, dass einer Erhebung nicht nur eine Warze (4) sondern zwei Warzen zugeordnet sind. Weiterhin sind die Warzen (4) und die ihnen zugeordneten Erhebungen (11) matrixartig angeordnet. Fig. 6d zeigt, dass jeweils einer Warze (4) zwei Erhebungen (11) zugeordnet sind.

## Patentansprüche

1. Umrichter in Druckkontaktierung bestehend aus
• einem Substrat (1) mit darauf angeordneten schaltungsgerecht miteinander verbundenen Halbleiterbauelementen
• einer Gleichstromzwischenkreisplatine (1) wobei das Substrat (1) und / oder die Gleichstromzwischenkreisplatine (1) Kontaktstellen (3) aufweisen, und besagte Kontaktstellen (3) verformbare Warzen (4) aufweisen und
• Stromanschlusselementen (10) für Gleich- und Wechselstromanschlüsse, wobei mindestens eines der Stromanschlusselemente (10) eine Mehrzahl von Erhebungen (11) aufweist, wobei
die Grundflächen der Warzen (4) durch die Erhebungen (11) jeweils nur teilweise überdeckt werden und die Warzen mittels der Druckkontaktierung durch die Erhebungen (11) derart verformt werden, dass die gemeinsame Kontaktfläche (12) einer Warze (4) und einer Erhebung (11) mindestens ein Fünftel der Grundfläche der Warze (4) aufweist.

2. Umrichter nach Anspruch 1, **dadurch gekennzeichnet, dass**
jeder Erhebung (11) genau eine Warze (4) zugeordnet ist.

3. Umrichter nach Anspruch 1, **dadurch gekennzeichnet, dass**
jeder Erhebung (11) mindestens zwei Warzen (4) zugeordnet sind.

4. Umrichter nach Anspruch 1, **dadurch gekennzeichnet, dass**
einer Warze (4) mehr als eine Erhebung (11) zugeordnet ist.

5. Umrichter nach Anspruch 1, **dadurch gekennzeichnet, dass**
die Warzen (4) und die Erhebungen (11) in Reihe angeordnet sind.

6. Umrichter nach Anspruch 1, **dadurch gekennzeichnet, dass**
die Warzen (4) und die zugeordneten Erhebungen (11) matrixartig angeordnet sind.

7. Umrichter nach Anspruch 1, **dadurch gekennzeichnet, dass**
die Warzen (4) aus einem Weichlot bestehen.

8. Umrichter nach Anspruch 1, **dadurch gekennzeichnet, dass**
die Stromanschlusselemente (10) mit den Erhebungen (11) einstückige Metallpressteile sind.

## Claims

1. A converter in pressure contacting comprising
• a substrate (1) with semiconductor elements arranged thereon connected to one another in keeping with the circuitry
• a direct current intermediate printed circuit board (1), whereby the substrate (1) and/or the direct current intermediate circuit board (1) have contact points (3), and said contact points (3) have deformable lugs (4) and
• current connection elements (10) for direct and alternating current connections, whereby at least one of the current connection elements (10) has a plurality of raised portions (11), whereby
the base faces of the lugs (4) are covered in each case only partially by the raised portions (11) and the lugs are deformed by the raised portions (11) by means of pressure contacting, in such a way that the common contact face (12) of a lug (4) and a raised portion (11) has at least a fifth of the base face of the lug (4).

2. The converter according to claim 1, **characterised in that** precisely one lug (4) is assigned to each raised portion (11).

3. The converter according to claim 1, **characterised in that** at least two lugs (4) are assigned to each raised portion (11).

4. The converter according to claim 1, **characterised in that** more than one raised portion (11) is assigned to a lug (4).

5. The converter according to claim 1, **characterised in that** the lugs (4) and the raised portions (11) are arranged in a row.

6. The converter according to claim 1, **characterised in that** the lugs (4) and the respective raised portions (11) are arranged matrix-like.

7. The converter according to claim 1, **characterised in that** the lugs (4) are made from a soft solder.

8. The converter according to claim 1, **characterised in that** the current connection elements (10) with the raised portions (11) are single-piece metal pressed parts.

## Revendications

1. Convertisseur à contact par pression, constitué :
• d'un substrat (1), sur lequel sont disposés des composants semi-conducteurs qui sont reliés entre eux en fonction des circuits,
• d'une platine de circuit intermédiaire à courant continu (1), le substrat (1) et/ou la platine de circuit intermédiaire à courant continu (1) comportant des points de contact (3), et lesdits points de contact (3) étant dotés de protubérances (4) déformables, et
• d'éléments de raccordement de courant (10) pour les raccordements de courant continu et alternatif, l'un au moins des éléments de raccordement de courant (10) comportant une pluralité de surélévations (11),
les surfaces de base des protubérances (4) n'étant respectivement recouvertes que partiellement par les surélévations (11), et les protubérances étant déformées par les surélévations (11) au moyen du contact par pression de telle sorte que la surface de contact commune (12) d'une protubérance (4) et d'une surélévation (11) soit au moins égale à un cinquième de la surface de base de la protubérance (4).

2. Convertisseur selon la revendication 1, **caractérisé en ce qu'**exactement une protubérance (4) est associée à chaque surélévation (11).

3. Convertisseur selon la revendication 1, **caractérisé en ce qu'**au moins deux protubérances (4) sont associées à chaque surélévation (11).

4. Convertisseur selon la revendication 1, **caractérisé en ce que** plus d'une surélévation (11) est associée à une protubérance (4).

5. Convertisseur selon la revendication 1, **caractérisé en ce que** les protubérances (4) et les surélévations (11) sont disposées en rangées.

6. Convertisseur selon la revendication 1, **caractérisé en ce que** les protubérances (4) et les surélévations (11) associées sont disposées en forme de matrice.

7. Convertisseur selon la revendication 1, **caractérisé en ce que** les protubérances (4) sont constituées d'un brasage tendre.

8. Convertisseur selon la revendication 1, **caractérisé en ce que** les éléments de raccordement de courant (10) avec les surélévations (11) sont des pièces métalliques estampées d'un seul tenant.
